# DEMANDE DE BREVET EUROPEEN

(11) **EP 2 665 086 A1**
(43) Date de publication de la demande: **20.11.2013**
(21) Numéro de dépôt: 13354016.1
(22) Date de dépôt: 15.05.2013
(51) Int. Cl.: H01L 21/033, H01L 21/308, H01L 21/8234

(54) **Procédé de réalisation d'un substrat muni de zones actives variées et de transistors planaires et tridimensionnels**

(30) Priorité: 16.05.2012 FR 1201412
(71) Demandeur: COMMISSARIAT A L'ENERGIE ATOMIQUE ET AUX ENERGIES ALTERNATIVES, 75015 Paris (FR)
(72) Inventeur: Andrieu, François, F-38000 Grenoble (FR); Barnola, Sébastien, F-38190 Villard-Bonnot (FR); Belledent, Jérôme, F-38240 Meylan (FR)
(74) Mandataire: Talbot, Alexandre

(57) **Abrégé**

Un substrat est muni successivement d'un support (7), d'une couche électriquement isolante (8), d'une couche en matériau semi-conducteur (2). Un premier masque (1) de protection recouvre complètement une deuxième zone (B) de la couche en matériau semi-conducteur (2) et laisse découvert une première zone (A) de la couche en matériau semi-conducteur (2). Un deuxième masque (3) de gravure recouvre partiellement la première zone (A) et au moins partiellement la deuxième zone (B), de manière à définir et séparer une première zone (A) et une deuxième zone (B). Des espaceurs latéraux sont formés sur les faces latérales du deuxième masque (3) de gravure de manière à former un troisième masque de gravure. La couche en matériau semi-conducteur (2) est gravée au moyen du troisième masque de gravure de manière à former un motif en matériau semi-conducteur dans la première zone (A), le premier masque (3) de gravure protégeant la deuxième zone (B).

## Description

### Domaine technique de l'invention

L'invention est relative à un procédé de réalisation d'un substrat de type semi-conducteur sur isolant.

### État de la technique

L'augmentation continue des performances des circuits intégrés, par exemple, en termes de consommation et/ou de fréquence de fonctionnement, se traduit inéluctablement par une diminution constante de la taille de ses composants et un accroissement de leur densité. Afin de réaliser des dispositifs toujours plus performants, de nouvelles techniques de définitions de motifs de petites tailles ont été mises en place.

De nouvelles architectures de dispositifs actifs, tel que des transistors, ont été réalisées. Ces nouvelles architectures ne présentent plus une structure planaire comme cela pouvait être le cas dans les technologies classiques, mais elles ont une intégration dite tridimensionnelle. Afin de réaliser simplement ces nouveaux types de transistors, par exemple des transistors FinFET, il est nécessaire de graver la couche semiconductrice du substrat pour définir tout le volume de matériau semi-conducteur utilisé par le dispositif. La diminution des dimensions du transistor se traduit par des difficultés dans la définition, en grande densité, des motifs de petites dimensions.

Cependant, dans un circuit intégré, il est également nécessaire d'avoir différents types de transistors, c'est-à-dire des transistors avec des dimensions différentes afin de pouvoir réaliser des fonctions bien spécifiques au moyen du transistor le plus adapté aux besoins identifiés. Il en résulte alors des difficultés importantes dans la réalisation de substrats comportant simultanément des zones semi-conductrices formées par un ou plusieurs plots de petites dimensions et des zones semi-conductrices formées par des zones actives beaucoup plus étendues.

Le document US2006/0081895 décrit la réalisation d'un dispositif semi-conducteur comportant des transistors de type FinFET et des transistors dits planaires.

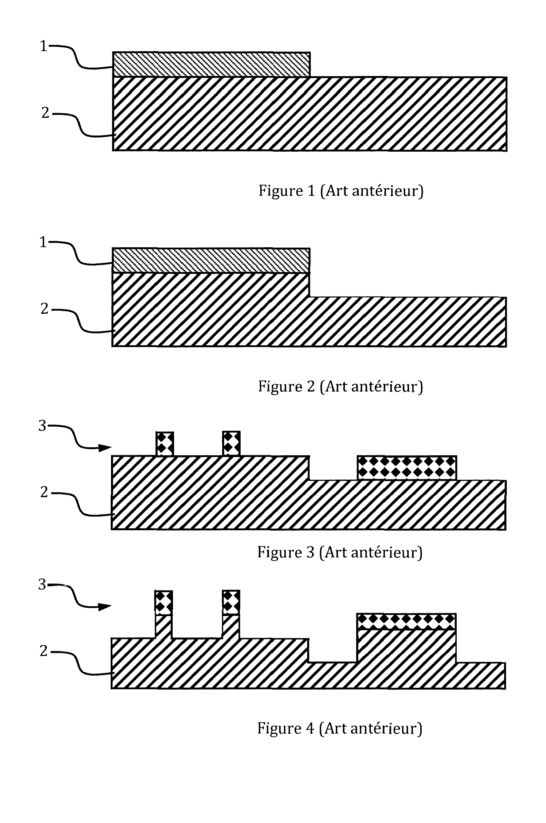

Comme illustré aux figures 1 et 2, un substrat en matériau semi-conducteur est partiellement recouvert par un premier masque 1. Le premier masque 1 est déposé sur le substrat de manière à définir deux surfaces complémentaires. Une des deux surfaces est gravée de manière à former une zone amincie, l'autre surface n'est pas gravée de façon à former une zone épaisse dans le matériau semi-conducteur 2.

Comme illustré à la figure 3, un deuxième masque 3 de gravure est formé de manière à définir les différentes zones actives du substrat. Ces zones actives sont définies dans les zones minces et dans les zones épaisses du film semi-conducteur 2.

Comme illustré à la figure 4, le film semi-conducteur 2 est gravé de manière à définir des zones actives dans la zone mince et dans la zone épaisse. La zone mince est gravée pour former des zones actives de grandes étendues pour l'intégration de transistors planaires. La zone épaisse est gravée pour former des motifs d'étendue réduite pour l'intégration de futurs transistors de type FinFET.

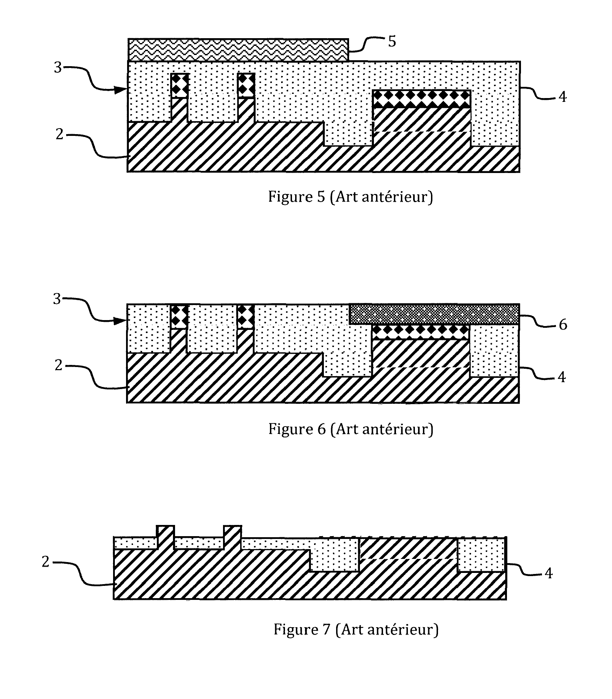

Comme illustré à la figure 5, un matériau diélectrique est déposé et aplani pour former un motif d'isolation 4 qui isole électriquement les différentes zones actives entre elles et qui recouvre les différentes zones actives de la zone mince. Une seconde étape de photolithographie est réalisée sur les zones épaisses pour former un troisième masque 5 de gravure qui protège les zones épaisses et le matériau diélectrique est gravé pour accéder au deuxième masque 3 de gravure et libérer le matériau semi-conducteur 2 situé en dessous.

Un second matériau diélectrique et une couche tampon 6 sont déposés. Comme illustré à la figure 6, la couche tampon 6 est aplanie de manière à libérer le deuxième masque 3 de gravure dans la zone épaisse et protéger le film semi-conducteur 2 dans la zone mince.

Comme illustré à la figure 7, le motif d'isolation 4 est partiellement éliminé et la couche tampon 6 est complètement éliminée pour accéder aux parois latérales des zones actives de la zone épaisse et aux zones actives de la couche mince.

On constate que ce procédé de réalisation est particulièrement difficile à mettre en oeuvre et il nécessite de nombreuses étapes de photolithographies ce qui limite les possibilités de former simultanément des zones de faible étendue avec une densité importante et des zones de plus grande étendue.

Ce procédé de mise en oeuvre est très difficile à utiliser car il est associé à un grand nombre de contraintes technologiques qui sont réparties dans les différentes étapes du procédé. Un problème identique existe vis-à-vis du document US2010/0291771 qui enseigne la formation de zones de faibles dimensions et de zones de grande taille avec la même étape de photolithographie et avec gravure du substrat massif. Le document US2010/0291771 utilise la technique de transfert par les espaceurs latéraux pour former des motifs de faible dimension.

### Objet de l'invention

On constate qu'il existe un besoin de prévoir un procédé de réalisation qui soit plus simple de mise en oeuvre pour former un substrat contenant des groupes de motifs avec une grande diversité dans le nombre de motifs réalisés par unité de surface donnée.

On tend à satisfaire ce besoin au moyen d'un procédé qui comporte les étapes suivantes :
- prévoir un substrat comprenant successivement :
   ○ une couche en matériau semi-conducteur,
   ○ un premier masque de protection recouvrant complètement une deuxième zone de la couche en matériau semi-conducteur et laissant découvert une première zone de la couche en matériau semi-conducteur,
   ○ un deuxième masque de gravure recouvrant partiellement la première zone et au moins partiellement la deuxième zone, de manière à définir une première zone et une deuxième zone,
   ○ un motif d'isolation traversant la couche en matériau semi-conducteur et agencé pour séparer et délimiter la première zone et la deuxième zone, le motif d'isolation et le premier masque séparant la couche de recouvrement et la deuxième zone,
- former des espaceurs latéraux sur les faces latérales du deuxième masque de gravure, les espaceurs latéraux formant un troisième masque de gravure,
- graver la couche en matériau semi-conducteur au moyen du troisième masque de gravure de manière à former un plot en matériau semi-conducteur dans la première zone, le premier masque de gravure protégeant la deuxième zone.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 7 représentent, de manière schématique, en vue de coupe des étapes successives de mise en oeuvre d'un premier procédé,
- les figures 8 à 18 représentent, de manière schématique, en vue de coupe ou en vue de dessus des étapes successives de mise en oeuvre d'un deuxième procédé,
- la figure 19 représente, de manière schématique, en vue de coupe une variante de réalisation en relation avec la figure 11,
- la figure 20 représente, de manière schématique, une vue en coupe d'une autre variante de réalisation en relation avec la figure 11,
- la figure 21 représente, de manière schématique, une vue en coupe d'un transistor planaire et plusieurs transistors de type FinFET.

### Description de modes de réalisation préférentiels de l'invention

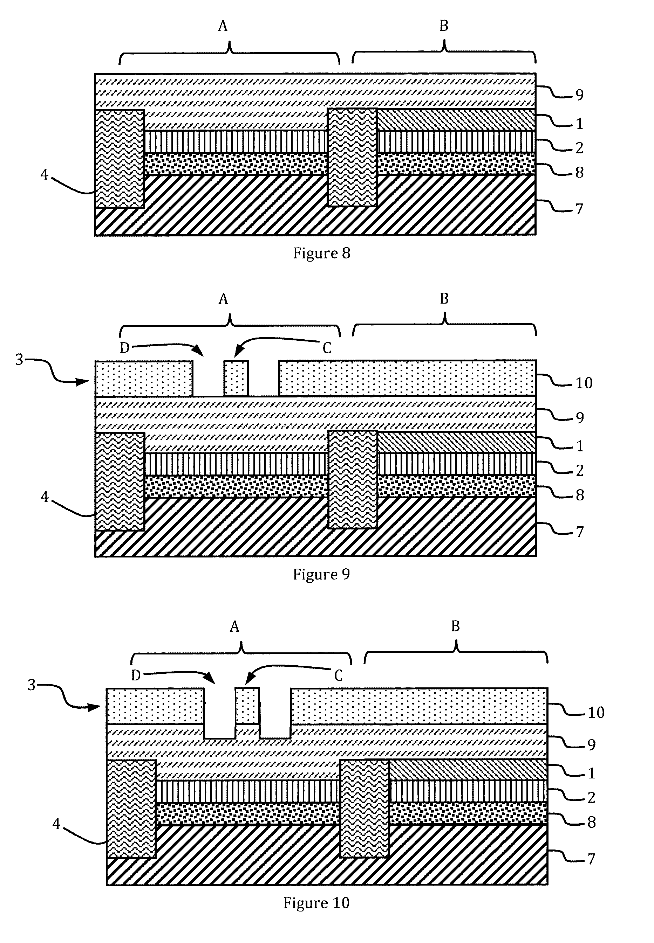

Le substrat de départ est un substrat massif ou un substrat de type semi-conducteur sur isolant. Le substrat massif comporte une couche en matériau semi-conducteur 2. Le substrat de type semi-conducteur sur isolant comporte un support 7 recouvert successivement par une couche électriquement isolante 8 et par une couche en matériau semi-conducteur 2, comme cela est illustré à la figure 8. La couche électriquement isolante 8 sépare le support 7 de la couche en matériau semi-conducteur 2. A titre d'exemple, le dispositif et le procédé décrit par la suite sont obtenus sur un substrat de type semi-conducteur sur isolant.

Un motif d'isolation 4 est avantageusement formé dans le substrat et il est configuré pour diviser la couche en matériau semi-conducteur 2 en au moins deux zones semi-conductrices distinctes. Le motif d'isolation 4 s'enfonce dans la couche en matériau semi-conducteur 2 afin de réaliser l'isolation électrique entre les différentes zones de la couche 2. Le motif d'isolation 4 peut également s'enfoncer dans la couche électriquement isolante 8 et éventuellement dans le support 7 afin d'augmenter la fiabilité des futurs dispositifs. Les différentes zones semi-conductrices sont définies et délimitées par le motif d'isolation 4, c'est-à-dire que le motif d'isolation 4 entoure et fixe les limites des différentes zones. Le motif d'isolation 4 est formé par un matériau électriquement isolant, par exemple un oxyde de silicium ou un nitrure de silicium. Le motif d'isolation 4 est réalisé de manière conventionnelle.

Un premier masque 1 de protection est formé sur la couche en matériau semi-conducteur 2 de manière à définir une première zone A et une deuxième zone B. La deuxième zone B de la couche en matériau semi-conducteur 2 est complètement recouverte par le premier masque 1 de protection (figure 8). La première zone A est dépourvue de couverture par le premier masque 1 de protection. Le dessin du masque 1 de protection est quelconque, il est défini en fonction des motifs désirés.

De manière avantageuse, le motif d'isolation 4 est configuré pour diviser la couche en matériau semi-conducteur 2 en une première zone A et une deuxième zone B selon le dessin défini par le premier masque 1 de protection. Le motif d'isolation 4 et le premier masque 1 peuvent être agencés de manière à ce que le dessin du premier masque soit identique au dessin de la deuxième zone B, mais il est également possible que le premier masque 1 s'étende en partie sur le motif d'isolation 4.

Avantageusement, le motif d'isolation 4 et le premier masque 1 réalisent la séparation entre la couche en matériau semi-conducteur 2 et les masques de gravure à venir. L'utilisation d'un motif d'isolation 4 entourant la première zone B et associé au premier masque 1 permet de mieux protéger les flancs de la couche en matériau semi-conducteur 2. De cette manière, il y a moins de gravure parasite sur les flancs de la couche 2 au fur et à mesure du procédé ce qui limite la présence de transistors parasites. De manière avantageuse, la deuxième zone B de la couche 2 est encapsulée entre le motif d'isolation 4, le premier masque 1 et la couche électriquement isolante 8 de manière à être protégée de toute agression durant la formation des motifs en matériau semi-conducteur dans la première zone A.

Le support 7 est, par exemple, un substrat en matériau semi-conducteur. De manière préférentielle, le support 7 est un substrat en silicium.

De manière avantageuse, la couche en matériau semi-conducteur 2 peut comporter des zones avec des épaisseurs différentes, par exemple la première zone A présente une épaisseur différente de la deuxième zone B. A titre d'exemple, la deuxième zone B a une épaisseur plus faible que la première zone A de manière à former des dispositifs planaires performants et des dispositifs FinFET également performants. Une configuration inverse est également envisageable.

Dans encore un autre mode de réalisation pouvant être combiné avec les modes précédents, la première zone A est formée dans un matériau différent de la deuxième zone B. Il est encore envisageable d'avoir des orientations cristallographiques différentes entre la première zone A et la deuxième zone B. Si plusieurs premières zones A sont formées sur le substrat, il peut y avoir des différences de matériaux, d'orientations cristallines et/ou d'épaisseurs entre les première zones A. Il peut en être de même entre les différentes zones B. Ces différences structurelles entre la zone A et la zone B peuvent être formées sur le substrat de départ par toute technique adaptée.

Un deuxième masque 3 de gravure est déposé sur le substrat de manière à recouvrir partiellement le substrat. Le deuxième masque 3 peut avoir une interface avec la couche 2 ou une couche intermédiaire peut être présente entre la couche 2 et le masque 3. Le deuxième masque 3 de gravure est configuré de manière à partiellement recouvrir la première zone A de sorte que la première zone A présente des zones recouvertes par le deuxième masque 3 et des zones découvertes. Le premier masque 1 de protection peut être complètement recouvert, partiellement recouvert ou complètement découvert par le deuxième masque 3. De manière avantageuse, le premier masque 1 de protection est complètement recouvert par le deuxième masque 3 de gravure. Il existe une sélectivité de gravure entre le matériau formant le premier masque 1 et le matériau formant le deuxième masque 3.

Le deuxième masque 3 de gravure est, par exemple, une résine photosensible ou un matériau de nature différente. Dans certains modes de réalisation, le deuxième masque 3 de gravure est en oxyde de silicium, en nitrure de silicium, un empilement de ces derniers ou un autre matériau. Lorsque le deuxième masque 3 de gravure n'est pas une résine, il est avantageux de définir sa forme au moyen d'une étape de photolithographie suivie d'une étape de gravure d'une couche de recouvrement 9 disposée sous un masque formé par photolithographie. Le deuxième masque 3 de gravure est également appelé masque dur.

Comme illustré aux figures 9 et 10, le deuxième masque 3 de gravure définit également une zone principale C et une zone secondaire D dans la première zone A du matériau semi-conducteur 2. La zone principale C est recouverte par le deuxième masque 3 de gravure et la zone secondaire D est découverte, elle est donc laissée libre. Le dessin du deuxième masque 3 de gravure est quelconque, il est défini en fonction des motifs désirés.

De manière avantageuse, la zone principale C s'étend de part et d'autre jusqu'au motif d'isolation 4 ce qui permet d'éviter la réalisation d'une étape de photolithographie supplémentaire pour la définition de la longueur du motif final. La longueur du motif final est définie par la dimension de la zone A de la couche en matériau semi-conducteur 2.

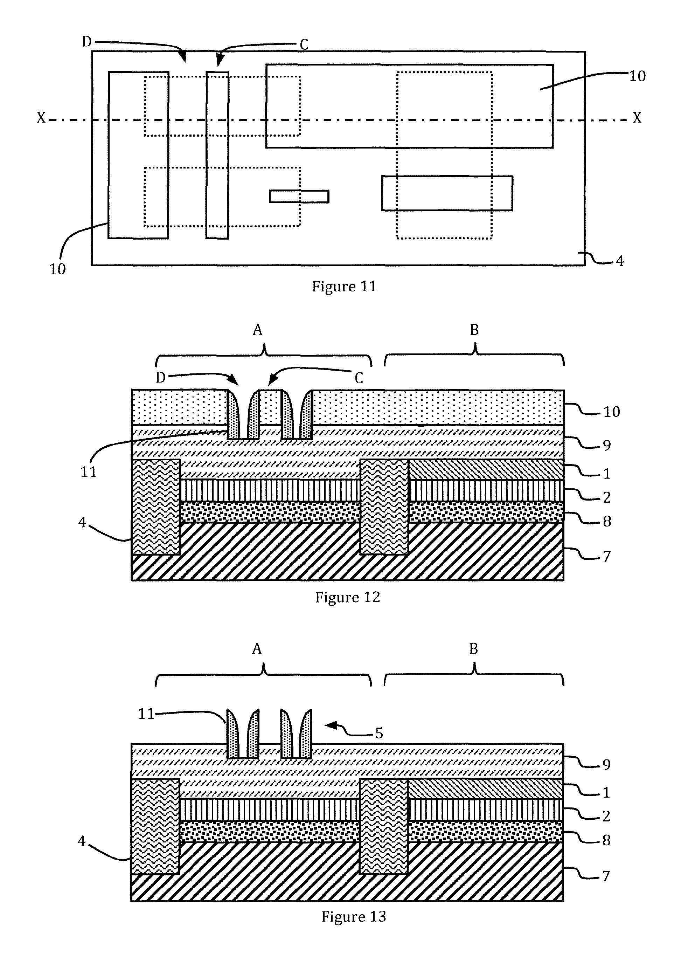

Dans un mode de réalisation particulier, illustré aux figures 10 et 11, une couche de recouvrement 9 est déposée sur le substrat de manière à recouvrir au moins partiellement le substrat. La couche de recouvrement 9 est agencée pour recouvrir le premier masque 1 de gravure et donc la deuxième zone B. Un masque provisoire 10 est déposé sur la couche de recouvrement 9 et il est configuré de manière à définir les zones C et D dans la couche de recouvrement 9 et former le deuxième masque 3 de gravure.

De manière avantageuse, la couche de recouvrement 9 recouvre complètement le substrat, c'est-à-dire la première zone A et la deuxième zone B. La couche de recouvrement 9 peut être formée par une ou plusieurs couches élémentaires. Dans un mode de réalisation particulier, la couche de recouvrement 9 est un matériau de type Spin On Carbon.

De manière avantageuse, le deuxième masque 3 de gravure recouvre complètement le dessin du premier masque 1 de protection. Cette configuration permet de limiter le nombre de matériaux présents à la surface du substrat ce qui facilite la définition du procédé de gravure. Ainsi, le premier masque 1 de protection est recouvert par le deuxième masque 3 de gravure.

La deuxième zone B de la couche 2 est recouverte directement par le premier masque 1 de protection et la première zone A de la couche 2 est recouverte directement par la couche de recouvrement 9 formant le deuxième masque 3. Le premier masque 1 de protection est disposé entre la couche en matériau semi-conducteur 2 et le deuxième masque 3, ici entre la couche en matériau semi-conducteur 2 et la couche de recouvrement 9. Le premier masque 1 empêche le contact direct entre la couche en matériau semi-conducteur 2 et la couche de recouvrement 9 dans la deuxième zone B.

Le premier masque 1 de protection est par exemple un oxyde de silicium, un nitrure de silicium, un mélange ou un empilement de ces derniers. Le premier masque 1 de protection peut être formé dans un autre matériau tant que la nature de ses constituants est compatible avec sa position entre la couche en matériau semi-conducteur 2 et la couche de recouvrement 9. A titre d'exemple, le premier masque 1 de protection a une épaisseur comprise entre 10 et 20nm.

A titre d'exemple, le matériau du deuxième masque 3 est un matériau carboné déposé par dépôt chimique en phase vapeur ou par dépôt à la tournette. Par exemple, le matériau utilisé est représenté par la formule CxHy ce qui traduit un matériau de type carbone plus ou moins hydrogéné, un matériau de type Spin On Carbon peut être utilisé. L'épaisseur du deuxième masque 3 est avantageusement comprise entre 20 et 100nm. De manière avantageuse, le matériau du deuxième masque 3 est un matériau à base de silicium et dont la composition est proche de SiO₂. Il est également possible d'utiliser un multicouche dont une des couches est à base de silicium. Le matériau du deuxième masque de gravure 3 peut comporter un matériau de type antireflet à base de silicium (Si AntiReflective Coating ou Si-ARC en anglais).

Comme cela est illustré à la figure 10, en coupe selon l'axe XX, le deuxième masque 3 est formé au moins partiellement dans le matériau de recouvrement 9 par toute technique de gravure adaptée, au moyen du masque provisoire 10. Selon les modes de réalisation, la couche de recouvrement 9 peut être gravée sur toute son épaisseur pour former le deuxième masque 3 au moyen du masque provisoire 10. Le masque provisoire 10 peut ensuite être conservé ou éliminé. Dans d'autres modes de réalisation, la couche de recouvrement 9 est gravée sur une partie de son épaisseur au moyen du masque provisoire 10. Le masque provisoire est ensuite éliminé et la couche de recouvrement 9 est de nouveau gravée de manière à former le deuxième masque 3 de gravure en découvrant une partie de la couche en matériau semi-conducteur 2. La différence d'épaisseur définie initialement dans la couche de recouvrement 9 au moyen du masque provisoire sert à définir le dessin final du deuxième masque 3 après gravure pour libérer partiellement la couche 2.

Dans encore un autre mode de réalisation, le second masque 3 de gravure est formé dans la couche de recouvrement 9 sans obligatoirement libérer une partie de la couche en matériau semi-conducteur 2 comme cela est illustré à la figure 10.

La figure 11 illustre, en vue de dessus, différents motifs du masque provisoire 10. Les différents motifs du masque provisoires définissent une ou plusieurs zones principales C et une ou plusieurs zones secondaires D. Différentes premières zones de la couche 2 (zones délimitées par des pointillées) sont représentées et sont entourées par le motif d'isolation 4. Le masque provisoire recouvre partiellement le motif d'isolation et les premières zones. Il est également possible que le masque provisoire recouvre complètement quelques premières zones 1. Selon les modes de réalisation, une zone principale C peut chevaucher un ou plusieurs premières zones A.

La partie du matériau de recouvrement 9 laissée libre est partiellement gravée de manière à former un motif en saillie dans la couche de recouvrement 9. Cette gravure partielle est représentée par des zones d'épaisseurs différentes. Dans la zone principale C recouverte par le deuxième masque 3 de gravure, l'épaisseur est inchangée et représente une zone épaisse. Dans la zone secondaire D découverte, la couche de recouvrement 9 a été partiellement éliminée et cela correspond à une zone mince de la couche 9.

Le dessin du deuxième masque 3 de gravure a été reproduit dans la couche de recouvrement 9 et le contour du dessin est formé par des parois latérales qui sont verticales ou sensiblement verticales et qui relient la zone mince à la zone épaisse. La zone mince a sensiblement le même dessin que la zone C et la zone épaisse a sensiblement le même dessin que la zone D. La gravure de la couche de recouvrement 9 étant réalisée sur une partie seulement de l'épaisseur du matériau de recouvrement, la hauteur de la paroi latérale dans la couche 9 est inférieure à l'épaisseur de la couche de recouvrement 9.

La couche de recouvrement 9 est donc gravée afin de former des zones avec des épaisseurs différentes ce qui se traduit par la présence de motifs en saillie dans la couche en matériau de recouvrement sur un film continu en matériau de recouvrement 9.

La couche de recouvrement 9 recouvre tout ou partie le matériau semi-conducteur 2 et le premier masque 1. Dans un mode de réalisation particulier, la couche en matériau semi-conducteur 2 et le premier masque 1 de protection sont complètement recouverts par la couche de recouvrement 9.

De manière avantageuse, la gravure est réalisée par plasma en imposant le temps de gravure ou en contrôlant l'épaisseur de gravure par réflectométrie in-situ.

Comme illustré à la figure 12, un matériau de masquage 11 est ensuite déposé de manière conforme ou le plus conforme possible sur l'ensemble et il recouvre le deuxième masque 3 de gravure. Dans certains modes de réalisation, le matériau de masquage 11 est en contact avec le deuxième masque 3 de gravure et la partie de la couche de recouvrement 9 qui ne forme pas le deuxième masque de gravure.

Dans un dépôt conforme, l'épaisseur déposée sur les parois verticales est identique à l'épaisseur déposée sur les parois horizontales. Une fois le matériau de masquage 11 déposé, ce dernier est gravé par toute technique adaptée, de préférence avec une gravure plasma anisotrope, afin de former des espaceurs latéraux. La gravure permet de localiser le matériau de masquage 11 sur les parois verticales définies dans le deuxième masque 3 de gravure, c'est-à-dire sur les parois verticales du deuxième masque 3 de gravure. De cette manière, après l'étape de gravure, le matériau de masquage 11 forme des espaceurs latéraux qui recouvrent les parois latérales du deuxième masque 3 de gravure, ici les parois latérales du matériau de recouvrement 9 et du masque provisoire 10.

Le matériau de masquage 11 peut être réalisé par tout matériau adapté, par exemple un matériau électriquement isolant ou conducteur. De manière préférentielle, le matériau de masquage 11 est réalisé en nitrure de silicium stoechiométrique ou non, en oxyde de silicium, en nitrure de titane, en oxyde d'hafnium ou en nitrure de bore. A titre d'exemple, le matériau de masquage 11 est déposé dans une gamme d'épaisseur comprise entre 5nm et 50nm. L'épaisseur déposée permet de définir la dimension latérale des motifs en matériau semi-conducteur.

Comme illustré à la figure 13, le masque provisoire 10 est éliminé afin de laisser à la surface, une partie du second masque 3 de gravure, la couche de recouvrement 9, le premier masque 1 de gravure et les espaceurs en matériau de masquage 11. Les espaceurs en matériau de masquage 11 forment un troisième masque 5 de gravure. Le dessin du troisième masque 5 de gravure est défini en partie par le dessin du deuxième masque 3 de gravure qui impose la position des espaceurs latéraux. Le dessin du troisième masque 5 de gravure est également défini à partir de l'épaisseur de matériau de masquage 11 déposé et de l'épaisseur gravée pour définir les dimensions des espaceurs latéraux.

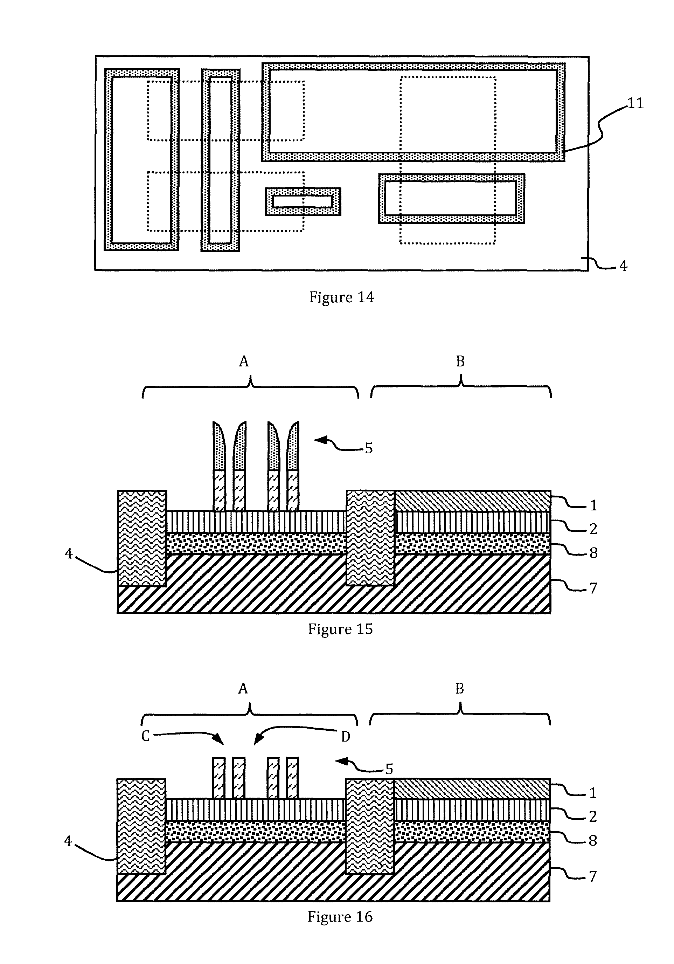

Comme cela est illustré à la figure 14, le matériau de masquage 11 forme un espaceur périphérique continu atour de chaque motif du masque 3. Ce dessin particulier du matériau de masquage 11 forme le troisième masque de gravure 5.

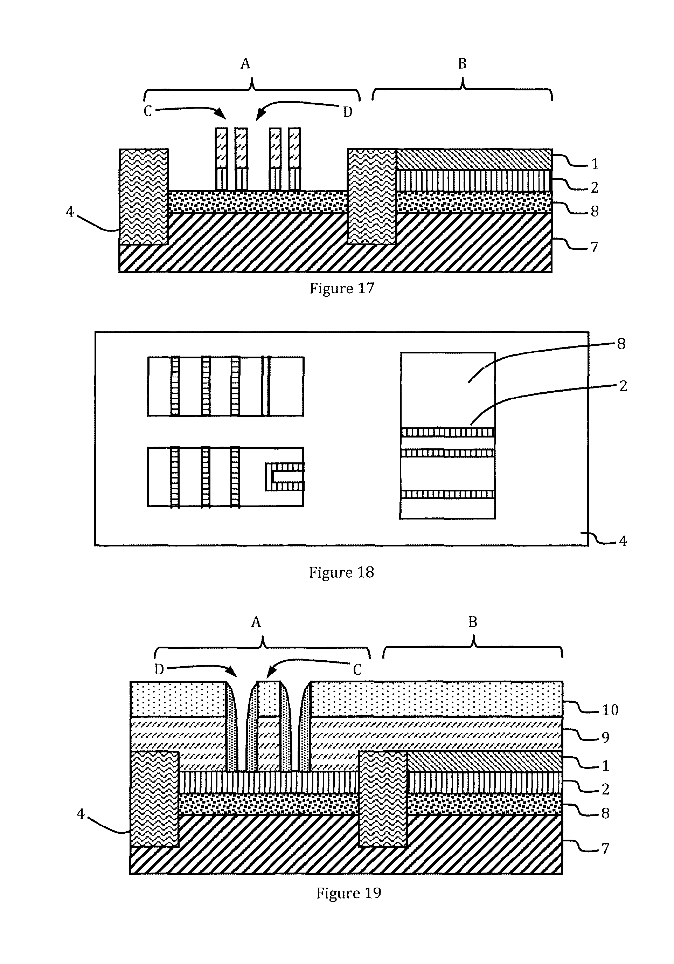

Comme cela est illustré à la figure 15, la couche de recouvrement 9 est gravée pour réaliser un nouveau masque de gravure formé par le matériau masquage ce qui définit un motif en saillie de la couche de recouvrement 9 qui est représentatif ou avantageusement identique au masque 5 de gravure. Comme cela est illustré aux figures 16 et 17, la première zone A de la couche en matériau semi-conducteur 2 est gravée au moyen des motifs de la couche de recouvrement 9 qui forment le troisième masque 5. Le premier masque 1 de protection empêche la gravure de la couche en matériau semi-conducteur 2 dans la zone B. De cette manière, il est possible de former simplement des motifs en matériau semi-conducteur de grandes dimensions et de petites dimensions. Les motifs de petites dimensions sont formés au moyen des espaceurs en matériau de masquage 11 ce qui permet une grande souplesse de réalisation, tant dans la densité d'intégration que dans les dimensions du motif à former. Les motifs de grandes dimensions sont formés au moyen du premier masque 1 de protection qui est réalisé directement par lithographie et gravure. De manière préférentielle, les motifs sont équidistants les uns des autres.

La figure 18 illustre en vue de dessus, les différents motifs en matériau semi-conducteur 2 à partir du troisième masque de gravure 5. Lorsque la zone principale C traverse complètement une première zone A, le troisième masque de gravure 5 traverse également la première zone A pour chevaucher les motifs d'isolation 4 de chaque côté. Lors de l'étape de gravure au moyen du troisième masque de gravure 5, le motif en matériau semi-conducteur 2 est défini par les dimensions du troisième masque 5 et par les dimensions de la première zone A. Le motif en matériau semi-conducteur est borné par le motif d'isolation 4. Ce mode de réalisation permet de définir une dimension du motif en matériau semi-conducteur au moyen de l'étape de délimitation de la première zone 1. Cependant, il est également possible de rajouter une étape supplémentaire de photolithographie et de gravure pour délimiter le motif en matériau semi-conducteur par rapport à ce qui est défini par les dimensions de la première zone A.

Lorsque la zone principale C ne traverse pas complètement une première zone A, il y a continuité du motif qui a par exemple la forme d'un U. pour éviter cette continuité et former deux motifs distincts, il est possible de réaliser une étape photolithographie et de gravure supplémentaire du troisième masque et/ou du motif semi-conducteur obtenu.

Les espaceurs en matériau de masquage 11 peuvent être éliminés avant de graver la couche 2 (figure 16), mais il est également possible de les conserver et de les éliminer seulement après la gravure de la couche 2. Les différents types de délimitations décrits plus-haut peuvent être combinés entre eux.

Cette intégration permet éventuellement de former sur un même substrat des zones semiconductrices avec une isolation électrique réalisée au moyen du motif d'isolation 4 et des zones semi-conductrices isolées électriquement par gravure de la couche 2, c'est-à-dire par élimination de la couche 2.

L'utilisation d'une couche de recouvrement 9 associée à un masque provisoire 10 laisse une grande souplesse sur l'épaisseur du second masque 3 de gravure lors de sa définition. Cette souplesse d'intégration permet d'améliorer la maîtrise des dimensions des espaceurs latéraux servant à définir le troisième masque 5 et donc les motifs dans la couche 2. Le choix de l'épaisseur du deuxième masque 3 permet de libérer les contraintes dans le procédé de dépôt du matériau de masquage et dans le procédé de gravure qui permet de former les espaceurs.

De manière avantageuse, les motifs de petites dimensions sont utilisés pour former des transistors tridimensionnels où plusieurs faces du motif sont utilisées pour commander le transit du courant, par exemple des transistors dits FinFET. Les motifs de grandes dimensions sont utilisés pour former des transistors planaires.

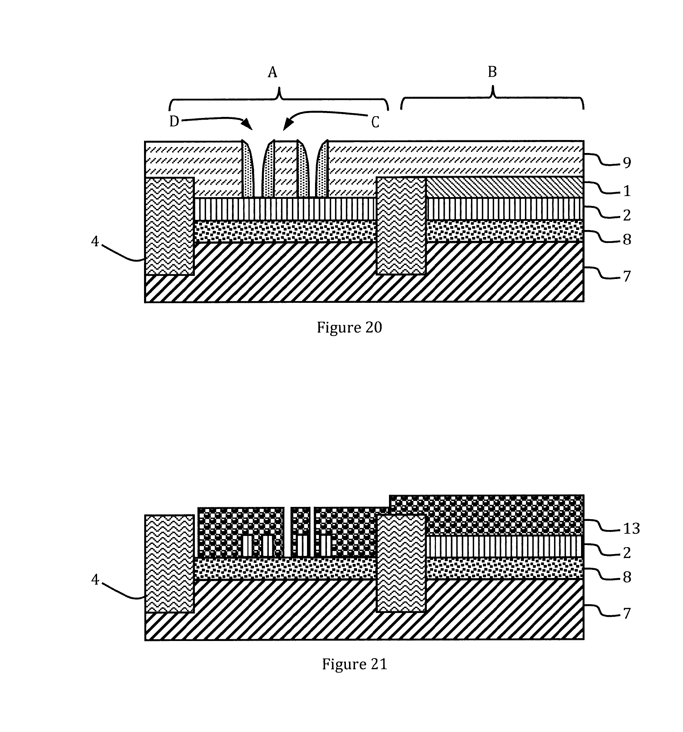

Dans le mode de réalisation illustré à la figure 19, le dessin du deuxième masque 3 de gravure a été défini dans la couche de recouvrement 9 à travers le masque provisoire 10 jusqu'à atteindre la couche 2 en matériau semi-conducteur. Le contour du dessin est formé par des parois latérales qui sont verticales ou sensiblement verticales et qui relient le haut du deuxième masque 3 à la couche 2. Le matériau de masquage 11 est déposé puis gravé comme précédemment de manière à former des espaceurs latéraux en contact avec la couche en matériau semi-conducteur 2. Le masque 3 est formé par l'association du masque provisoire 10 et de la couche de recouvrement 9. Dans ce mode de réalisation, il est possible d'éliminer le masque provisoire 10 après formation des espaceurs latéraux ou avant formation des espaceurs latéraux comme cela est illustré à la figure 20. Les figures 12, 19 et 20 montrent trois variantes de définition du deuxième masque 3.

De manière générale, le procédé de réalisation des motifs dans la zone A peut être résumé de la manière suivante :
- former des espaceurs latéraux sur les faces latérales du deuxième masque 3 de gravure de manière à former un troisième masque 5 de gravure,
- graver la couche en matériau semi-conducteur 2 au moyen du troisième masque 5 de gravure de manière à former un motif en matériau semi-conducteur dans la première zone A, le premier masque 1 de gravure protégeant la deuxième zone B.

Les motifs en matériau semi-conducteur sont formés dans la première zone A, leur épaisseur a été définie préalablement lors de la définition des caractéristiques de la première zone A. Si plusieurs premières zones A sont formées, il est possible de définir des zones avec des caractéristiques différentes sans que cela ne modifie fortement l'étape de définition des motifs en matériau semi-conducteur. Les motifs en matériau semi-conducteur 2 reproduisent le dessin du troisième masque 5 de gravure.

Le premier masque 1 de gravure peut être ensuite éliminé de manière à permettre l'accès à la deuxième zone B en matériau semi-conducteur par exemple pour former un transistor ou un autre dispositif.

Ce mode de mise en oeuvre est particulièrement avantageux car il permet de réaliser simplement un substrat avec des zones semi-conductrices ayant une taille importante, et avantageusement de réaliser la deuxième zone B recouverte par le premier masque 1 et des zones avec une taille réduite à l'intérieur de la première zone A.

Les motifs semi-conducteurs dans la première zone A proviennent des dimensions des espaceurs, il est donc possible de se soustraire des erreurs de control dimensionnel liées aux étapes de photolithographies.

Dans un mode de réalisation particulier qui peut être combiné avec les modes précédents, il est possible de réaliser une implantation ionique d'impuretés électriquement actives dans le support. L'impureté introduite est avantageusement choisie parmi l'arsenic, le bore, l'indium et le phosphore. L'impureté dopante est implantée dans le support sur une profondeur comprise entre 10nm et 500nm depuis l'interface entre le support 7 et la couche électriquement isolante 8.

Eventuellement, le premier masque 1 de protection est utilisé pour moduler l'épaisseur d'implantation de l'impureté dopante dans le support, par exemple en bloquant l'impureté dopante ou en faisant que cette impureté dopante est implantée dans la couche électriquement isolante 8 et non dans le support. De cette manière, il est possible de définir simplement une contre-électrode et avantageusement un dispositif d'isolation électrique par diode pn ou np dans le support 7 face à la première zone A. Dans d'autres cas de figure, des étapes additionnelles de photolithographies sont possibles pour définir les zones à implanter et les zones à protéger.

Dans un autre mode de réalisation qui peut être combiné avec les modes précédents, deux motifs adjacents formés dans la zone A peuvent être connectés au moyen du dépôt sélectif d'un matériau électriquement conducteur. De manière préférentielle, une épitaxie sélective est réalisée à partir des motifs de manière à faire croitre latéralement un matériau semi-conducteur, par exemple du silicium, pour obtenir la connexion avec les motifs adjacents. Le motif de départ peut être partiellement masqué de manière à localiser la zone de connexion avec le motif adjacent. De manière avantageuse, la zone de contact entre les deux motifs adjacents est siliciurée afin de réduire l'importance des éventuels défauts sur les performances électriques finales du dispositif.

Comme illustré à la figure 21, un matériau diélectrique de grille qui est électriquement isolant peut ensuite être déposé ou formé, de manière avantageuse sur tout le substrat et de manière encore plus avantageuse sur la première zone A et sur la deuxième zone B. Cependant, afin de réaliser une spécialisation des dispositifs entre la première zone A et la deuxième B, il est possible de former un deuxième diélectrique de grille soit dans la première zone A, soit dans la deuxième zone B.

Une électrode de grille 12 qui est électriquement conductrice est ensuite formée, par exemple par dépôt du matériau adapté et sa gravure. Des espaceurs latéraux additionnels sont éventuellement formés et une implantation peut être réalisée par la suite pour définir les électrodes de source et de drain du transistor. Dans l'exemple de la figure 20, une électrode de grille est commune à deux motifs semi-conducteurs de la première zone A, c'est-à-dire à deux transistors de la première zone A. Il y a également une électrode de grille commune à un transistor de la première zone A et à un transistor de la deuxième zone B.

Une siliciuration partielle des électrodes de source et de drain est avantageusement réalisée avant la formation d'un contact électriquement conducteur pour réduire la résistance d'accès. Il peut en être de même pour l'électrode de grille.

De manière avantageuse, le premier masque 1 est réalisé de manière classique, c'est-à-dire par une technique autre que par transfert d'espaceurs latéraux, il est possible d'obtenir des motifs ayant une largeur importante. Il est alors aisé d'aligner le second masque 3 de gravure par rapport au premier masque 1.

L'utilisation d'un premier masque 1 obtenu avec la technique de transfert d'espaceurs latéraux impose des motifs de petite taille ce qui rend difficile l'alignement des niveaux photolithographiques suivants. Il est donc particulièrement intéressant de former le premier masque 1 de manière classique pour faciliter les différents alignements des niveaux photolithographiques successifs. Cette configuration permet de réduire la topologie de surface et donc l'emploi de matériau aplanissant. Une forte topologie induit des disparités de réflectivité pour la lithographie qui nuisent à l'obtention de la résolution recherchée. Cette forte topologie induit également des différences locales de températures qui sont fonction de la densité des motifs sous-jacents et qui modifient les dimensions des motifs au final.

Au contraire dans le procédé décrit, le premier masque 1 qui définit les première et deuxième zones est réalisé sur une surface sans topologie et présente une épaisseur avantageusement plus faible que le masque 5 de gravure formé par la technique de transfert d'espaceurs latéraux. Ainsi, l'effet du premier masque 1 sur la définition du deuxième masque 3 de gravure est réduit.

Dans un mode de réalisation particulier, des différences entre le dessin initial du masque 5 ou du masque 6 peuvent exister si la gravure du matériau de recouvrement 9 comporte une composante isotrope ou si une étape de rétrécissement (trimming) diminue la taille des motifs ou fait disparaître les plus petits motifs.

Dans la variante de réalisation illustrée à la figure 19, le masque provisoire 10 est éliminé avant de déposer le matériau de masquage 11 et de former les espaceurs latéraux. La hauteur des espaceurs latéraux est définie à partir de l'enfoncement dans le matériau de recouvrement 9 ce qui laisse les mêmes marges de manoeuvre que dans les modes de réalisation précédent. Cette variante est particulièrement avantageuse car elle ne nécessite qu'une sélectivité de gravure entre le matériau du masque provisoire et le matériau de recouvrement 9, ce qui relâche les contraintes dans le choix des matériaux.

La gravure du matériau de recouvrement 9 sur une partie de son épaisseur permet de libérer au moins partiellement ces contraintes. L'étape de photolithographie est réalisée sur une certaine épaisseur de matériau de recouvrement 9. Cette épaisseur est choisie afin de faciliter l'étape de photolithographie. La couche en matériau de recouvrement 9 est ensuite gravée pour former une zone épaisse et une zone mince et cette différence d'épaisseur est utilisée pour faciliter la définition des espaceurs latéraux avec le rapport dimensionnel choisi. La définition des espaceurs est facilitée car un plus grand choix de matériaux est accessible, les difficultés à obtenir un dépôt conforme étant en partie gommées par la souplesse dans le choix de la différence d'épaisseur entre la zone mince et la zone épaisse.

Lorsque le substrat est un substrat massif, il est avantageux de réaliser une isolation électrique d'un ou plusieurs motifs par rapport au reste du substrat par tout moyen adapté, par exemple au moyen d'une ou plusieurs diodes formées dans le substrat.

De manière également avantageuse, le substrat peut comporter des zones dites massives et des zones présentant une structure de type semi-conducteur sur isolant. Dans cette configuration, il est préférable de réaliser la première zone A dans une zone de type semi-conducteur sur isolant.

## Revendications

1. Procédé de réalisation d'un substrat comportant les étapes suivantes :
- prévoir un substrat comprenant successivement :
○ une couche en matériau semi-conducteur (2),
○ un premier masque (1) de protection recouvrant complètement une deuxième zone (B) de la couche en matériau semi-conducteur (2) et laissant découvert une première zone (A) de la couche en matériau semi-conducteur (2),
○ un deuxième masque (3) de gravure recouvrant partiellement la première zone (A) et au moins partiellement la deuxième zone (B), de manière à définir la première zone (A) et la deuxième zone (B),
○ un motif d'isolation (4) traversant la couche en matériau semi-conducteur (2) et agencé pour séparer et délimiter la première zone (A) et la deuxième zone (B), le motif d'isolation (4) et le premier masque (1) séparant la couche de recouvrement (9) et la deuxième zone (B),
- former des espaceurs latéraux sur les faces latérales du deuxième masque (3) de gravure, les espaceurs latéraux formant un troisième masque (5) de gravure,
- graver la couche en matériau semi-conducteur (2) au moyen du troisième masque (5) de gravure de manière à former un motif en matériau semi-conducteur dans la première zone (A), le premier masque (1) de gravure protégeant la deuxième zone (B).

2. Procédé selon la revendication 1, **caractérisé en ce qu'il** comporte le dépôt d'une couche de recouvrement (9), la formation d'un masque provisoire (10) sur la couche de recouvrement (9) et la gravure de la couche de recouvrement (9) au moyen du masque provisoire (10) pour former le deuxième masque (3) de gravure.

3. Procédé selon la revendication 2, **caractérisé en ce qu'il** comporte la gravure partielle de la couche de recouvrement (9) avant le dépôt d'un matériau de masquage (11) formant les espaceurs du troisième masque (5).

4. Procédé selon la revendication 3, **caractérisé en ce que** le troisième masque (5) de gravure comporte des motifs provenant de la couche de recouvrement surmontés par les espaceurs.

5. Procédé selon la revendication 4, **caractérisé en ce qu'il** comporte l'élimination des espaceurs avant la gravure de la couche en matériau semi-conducteur, le troisième masque (5) de gravure étant formé par la couche de recouvrement (9).

6. Procédé selon l'une quelconque des revendications 1 à 5, **caractérisé en ce qu'il** comporte :
- l'élimination du premier masque (1) et du troisième masque (5) de gravure pour libérer les motifs en matériau semi-conducteur de la couche en matériau semi-conducteur (2),
- le dépôt d'un diélectrique de grille et d'une électrode de grille sur la couche en matériau semi-conducteur pour définir un premier transistor dans la première zone (A) et un deuxième transistor dans la deuxième zone (B).

7. Procédé selon l'une quelconque des revendications 1 à 6, **caractérisé en ce que** le substrat comporte dans la première zone (A) un support (7), une couche électriquement isolante (8) et la couche en matériau semi-conducteur (7).
